# EUROPEAN PATENT SPECIFICATION

(11) **EP 3 996 469 B1**
(45) Date of publication and mention of the grant of the patent: **07.10.2026**
(21) Application number: 20216940.5
(22) Date of filing: 23.12.2020
(51) Int. Cl.: H05B 6/06

(54) **HIGH-FREQUENCY ELECTROMAGNETIC INDUCTION CONTROL CIRCUIT**
ELEKTROMAGNETISCHE HOCHFREQUENZ-INDUKTIONSSTEUERSCHALTUNG
CIRCUIT DE COMMANDE D'INDUCTION ÉLECTROMAGNÉTIQUE HAUTE FRÉQUENCE

(30) Priority: 10.11.2020 CN 202011250692
(43) Date of publication of application: 11.05.2022
(73) Proprietor: Shenzhen Eigate Technology Co., Ltd., Shenzhen, Guangdong 518103 (CN)
(72) Inventor: LIU, Tuanfang, Shenzhen, Guangdong 518000 (CN)
(74) Representative: Scholl, Matthias

(56) References cited:
- EP-A1- 3 632 234
- EP-A2- 2 372 261
- JP-A- 2004 016 416
- JP-A- H08 173 316

## Description

The disclosure relates to a high-frequency electromagnetic induction control circuit.

Conventionally, a metal resistor is directly heated by current from a control circuit, without the use of an electromagnetic induction control circuit. For example, JP 2004 016416 A discloses a heating circuit for a rice cooker; and EP 2372261 A2 discloses a heating circuit in an air conditioner.

The disclosure provides a high-frequency electromagnetic induction control circuit as defined by claim 1, and comprises a charging control circuit, a battery control and protection circuit, a battery, a main control MCU, a display control circuit, a keyboard control circuit, a drive circuit, a high-frequency heating circuit, and an induction heating circuit. The charging control circuit supplies a charging voltage and a charging current for the battery; the battery control and protection circuit is configured to detect whether the charging voltage and the charging current are qualified; the battery supplies power for the main control MCU; the main control MCU is configured to detect an input voltage of the battery, and the display control circuit sends out a signal whether the battery is in an under-voltage state; the keyboard control circuit is configured to control the main control MCU to operate; an output voltage of the main control MCU is boosted by the drive circuit; a boosted voltage is oscillated in the high-frequency heating circuit to produce an electromagnetic wave thus generating a high-frequency alternating voltage and current; the high-frequency alternating voltage and current is output to the induction heating circuit to produce an induced magnetic field and an eddy current is formed in a metal placed in the induction heating circuit, and the metal is heated through electromagnetic induction effect.

In a class of this embodiment, the charging control circuit is configured to convert a household 220V/23A alternating current into a 5V/1A DC charging voltage and charging current for the battery.

In a class of this embodiment, the battery control and protection circuit is configured to detect whether the charging voltage and charging current meet the voltage and current required by the battery, thus achieving the functions of over-current and over-voltage protection.

In a class of this embodiment, the battery comprises at least two cells connected in series or in parallel to supply power for the main control MCU and each circuit.

In a class of this embodiment, the main control MCU is configured to detect whether the battery is in the under-voltage state after the battery supplies power to the main control MCU; if so, the main control MCU feeds back the signal regarding to the under-voltage state to the display control circuit and the charging control circuit; the display control circuit sends out the signal, and the charging control circuit receives the signal and continues to charge the battery until the battery is fully charged.

In a class of this embodiment, the keyboard control circuit is configured to control the main control MCU to operate or stop operating, to switch a working mode and power of the main control MCU, to feed back information with regard to a working state, the working mode and power of the main control MCU to the display control circuit; and the display control circuit is configured to display the information.

In a class of this embodiment, the drive circuit is equivalent to a step-up transformer to increase the DC voltage from the battery.

In a class of this embodiment, the high-frequency heating circuit comprises a capacitor and an inductor; the high-frequency heating circuit is configured to oscillate the DC voltage output from the drive circuit to produce the electromagnetic wave, and to change positive and negative directions of the DC voltage periodically, thereby generating the high-frequency alternating voltage and current, and to output the high-frequency alternating voltage and current to the induction heating circuit.

In a class of this embodiment, the induction heating circuit comprises a metal coil and a metal container; the high-frequency alternating voltage and current pass through the metal coil to produce the induced magnetic field, and the metal container is heated in the induced magnetic field.
FIG. 1 is a connection diagram of a circuit L1 in accordance with one embodiment of the disclosure;
FIG. 2 is a connection diagram of a circuit D2 in accordance with one embodiment of the disclosure;
FIG. 3 is a connection diagram of a circuit L2 in accordance with one embodiment of the disclosure;
FIG. 4 is a connection diagram of a circuit J2 in accordance with one embodiment of the disclosure;
FIG. 5 is a connection diagram of a circuit Q9 in accordance with one embodiment of the disclosure;
FIG. 6 is a connection diagram of a circuit Q16 in accordance with one embodiment of the disclosure;
FIG. 7 is a connection diagram of a circuit C32 in accordance with one embodiment of the disclosure;
FIG. 8 is a connection diagram of a circuit C20 in accordance with one embodiment of the disclosure;
FIG. 9 is a connection diagram of a circuit C23 in accordance with one embodiment of the disclosure;
FIG. 10 is a connection diagram of a circuit R15 in accordance with one embodiment of the disclosure;
FIG. 11 is a connection diagram of a circuit C16 in accordance with one embodiment of the disclosure;
FIG. 12 is a connection diagram of a circuit L5 in accordance with one embodiment of the disclosure;
FIG. 13 is a connection diagram of a circuit U1 in accordance with one embodiment of the disclosure;
FIG. 14 is a connection diagram of a circuit C18 in accordance with one embodiment of the disclosure;
FIG. 15 is a connection diagram of a circuit R87 in accordance with one embodiment of the disclosure;
FIG. 16 is a connection diagram of a circuit U3 in accordance with one embodiment of the disclosure;
FIG. 17 is a connection diagram of a circuit D4 in accordance with one embodiment of the disclosure;
FIG. 18 is a connection diagram of a circuit R48 in accordance with one embodiment of the disclosure;
FIG. 19 is a connection diagram of a circuit U8 in accordance with one embodiment of the disclosure;
FIG. 20 is a connection diagram of a circuit R73 in accordance with one embodiment of the disclosure;
FIG. 21 is a connection diagram of a circuit U2 in accordance with one embodiment of the disclosure;
FIG. 22 is a connection diagram of a circuit D10 in accordance with one embodiment of the disclosure;
FIG. 23 is a connection diagram of a circuit R9 in accordance with one embodiment of the disclosure;
FIG. 24 is a connection diagram of a circuit R55 in accordance with one embodiment of the disclosure;
FIG. 25 is a connection diagram of a circuit R81 in accordance with one embodiment of the disclosure;
FIG. 26 is a connection diagram of circuits P73, P74 and P75 in accordance with one embodiment of the disclosure;
FIG. 27 is a connection diagram of a circuit C28 in accordance with one embodiment of the disclosure;
FIG. 28 is a connection diagram of a circuit R38 in accordance with one embodiment of the disclosure;
FIG. 29 is a connection diagram of a circuit R70 in accordance with one embodiment of the disclosure;
FIG. 30 is a connection diagram of a circuit D10 in accordance with one embodiment of the disclosure;
FIG. 31 is a connection diagram of a circuit C45 in accordance with one embodiment of the disclosure;
FIG. 32 is a connection diagram of a circuit Q23 in accordance with one embodiment of the disclosure;
FIG. 33 is a connection diagram of a circuit Q21 in accordance with one embodiment of the disclosure; and
FIG. 34 is a schematic diagram of high-frequency electromagnetic induction control circuit in accordance with one embodiment of the disclosure.

To further illustrate, embodiments detailing a high-frequency electromagnetic induction control circuit are described below. It should be noted that the following embodiments are intended to describe and not to limit the disclosure.

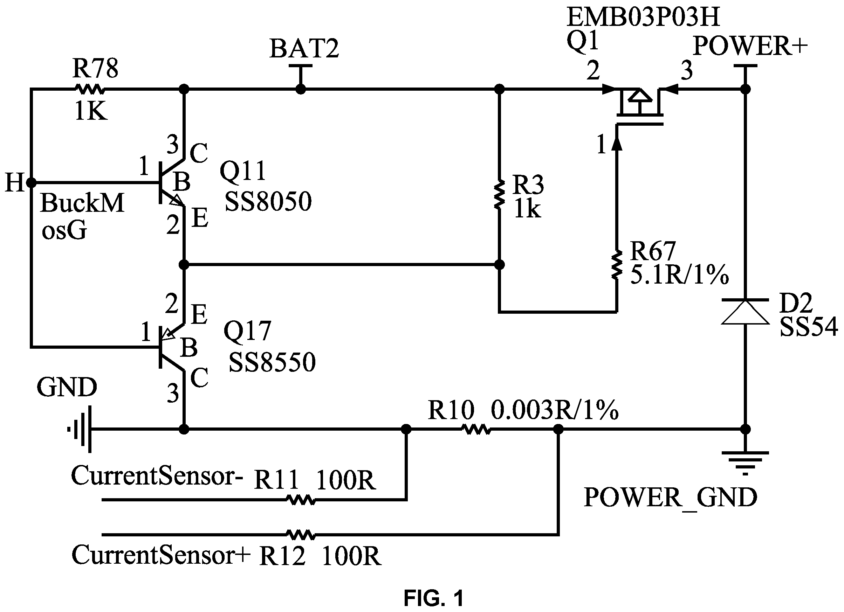

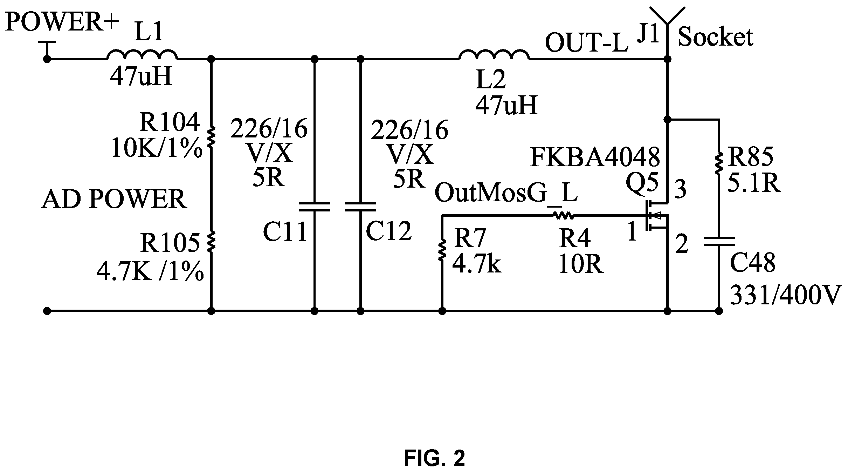

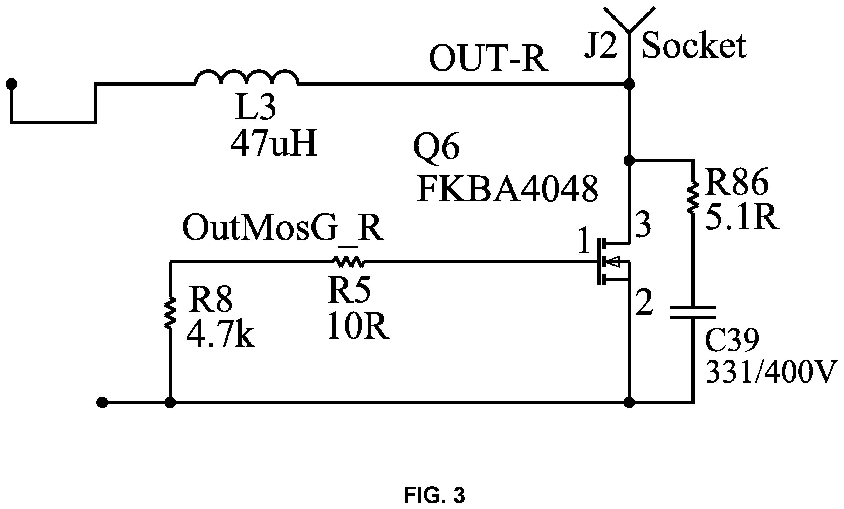

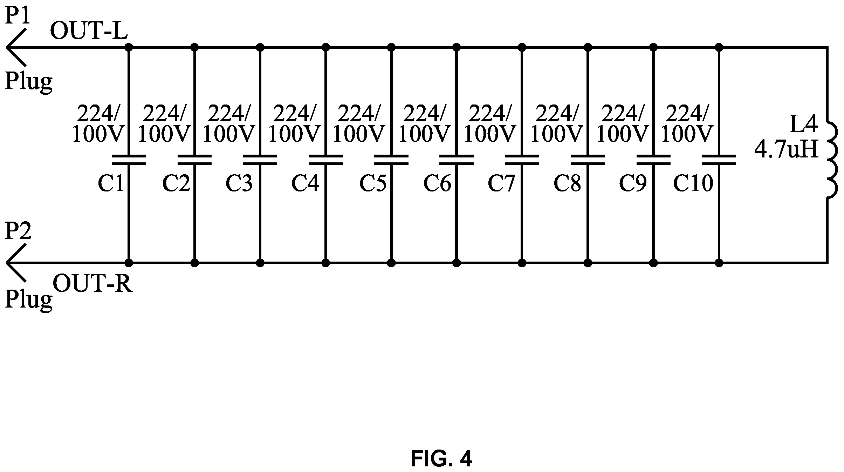

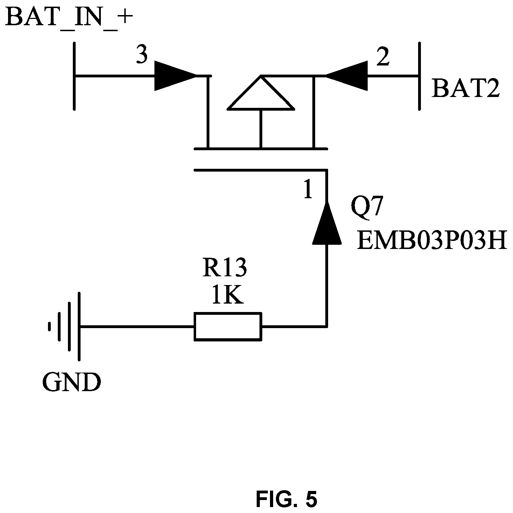

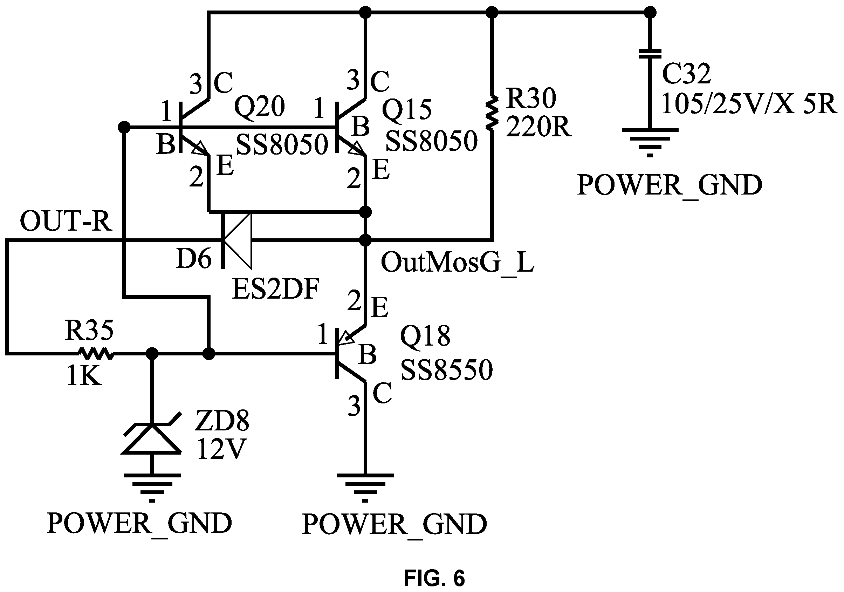

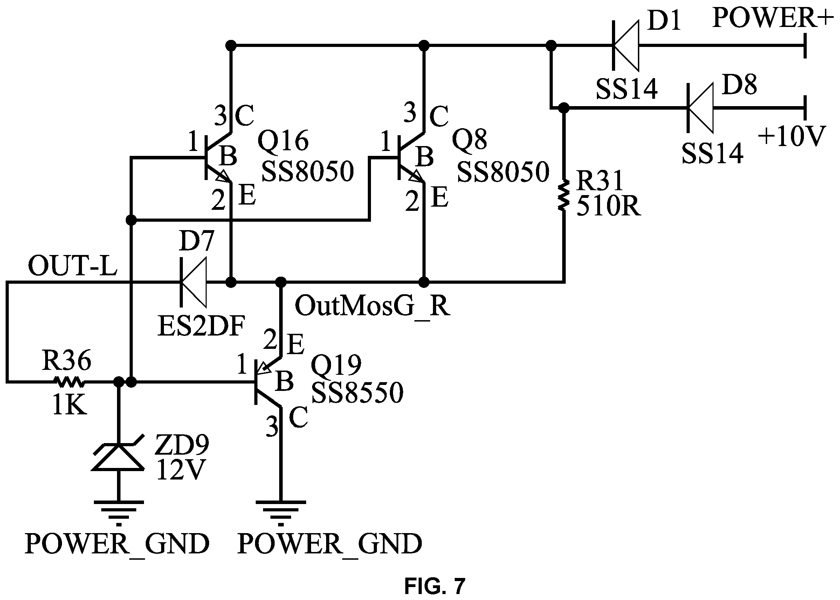

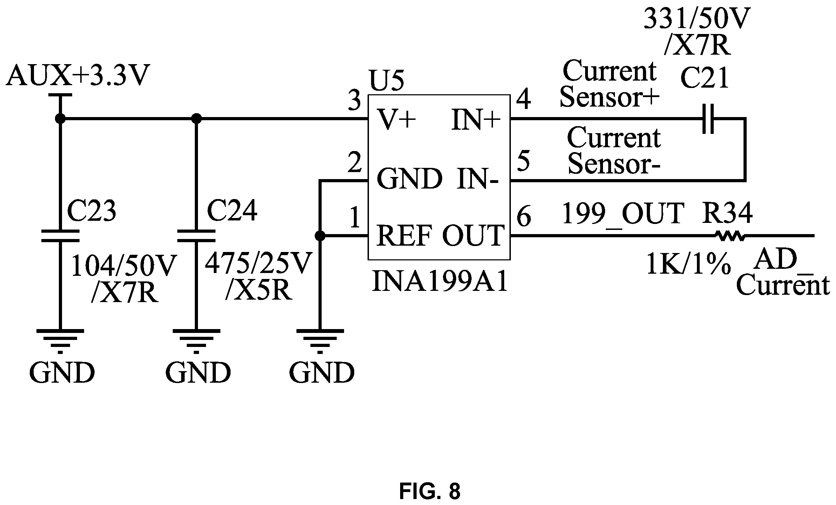

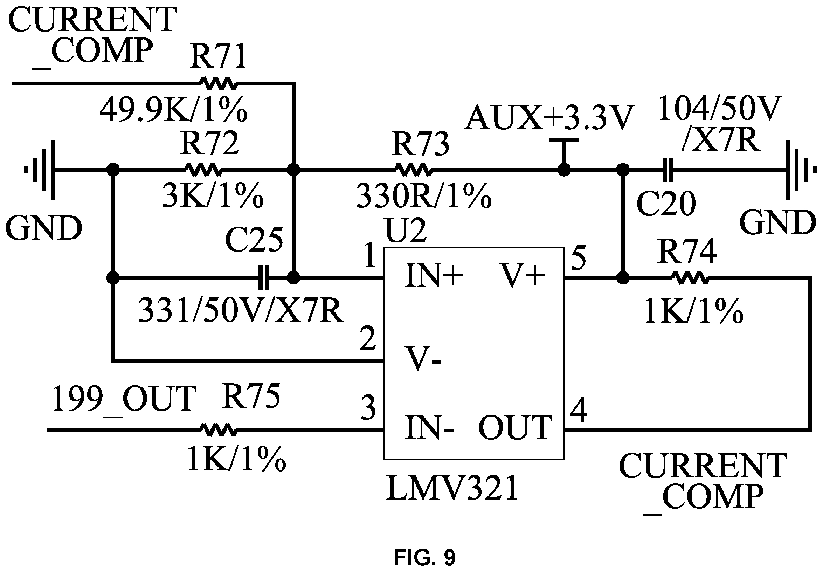

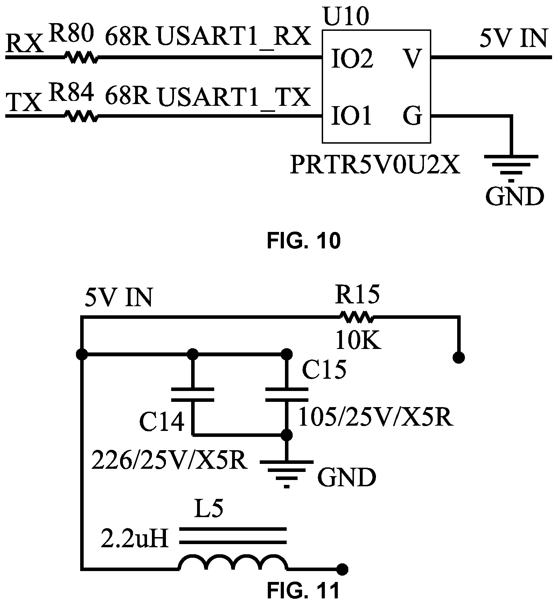

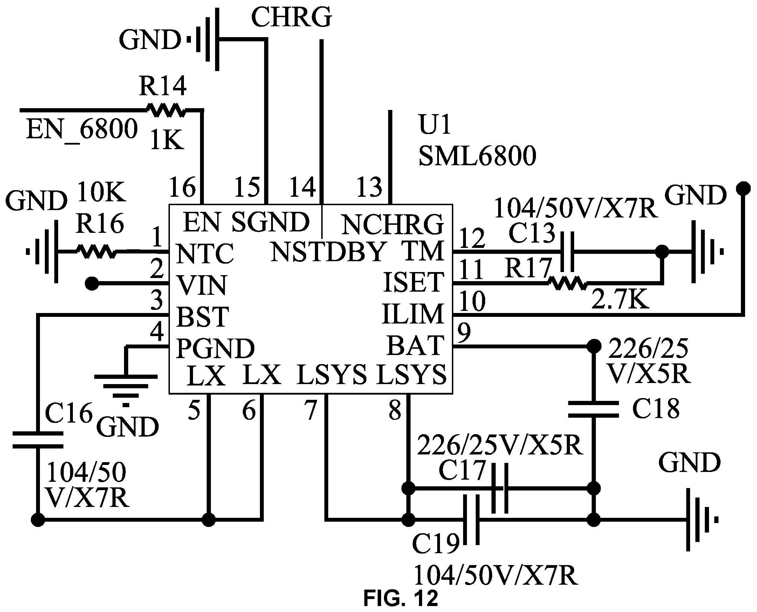

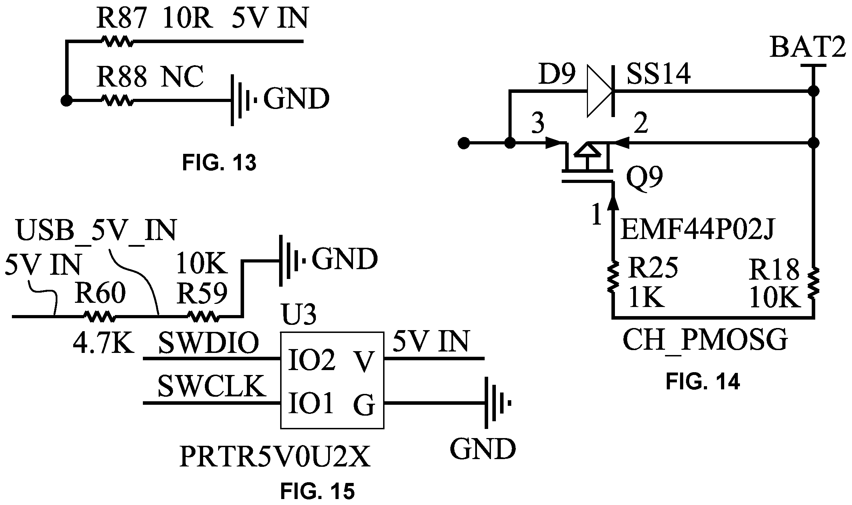

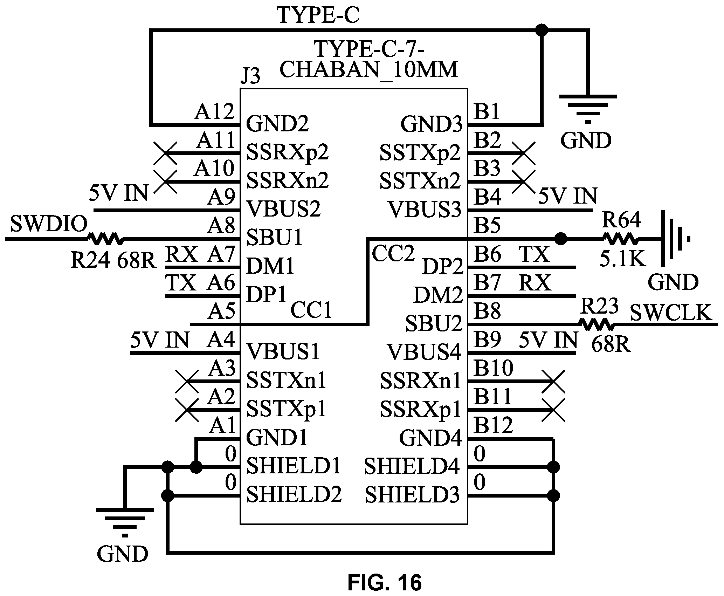

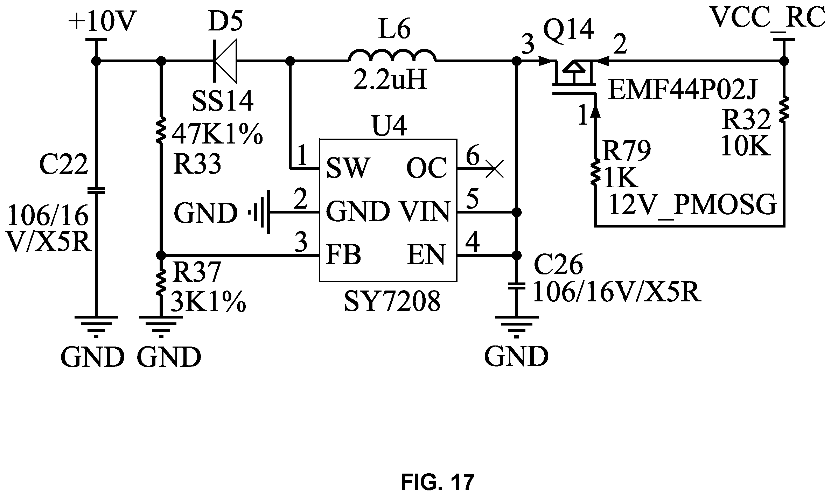

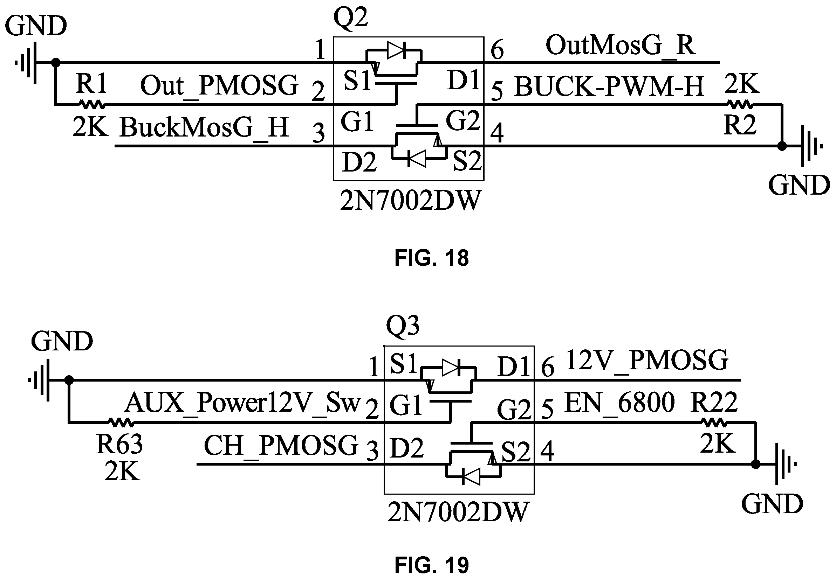

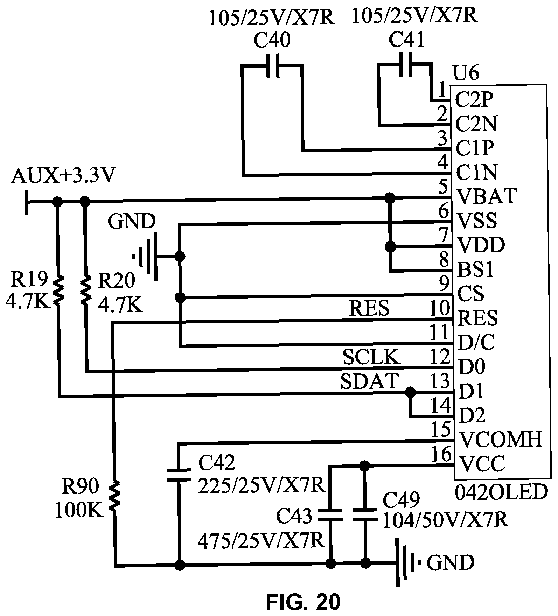

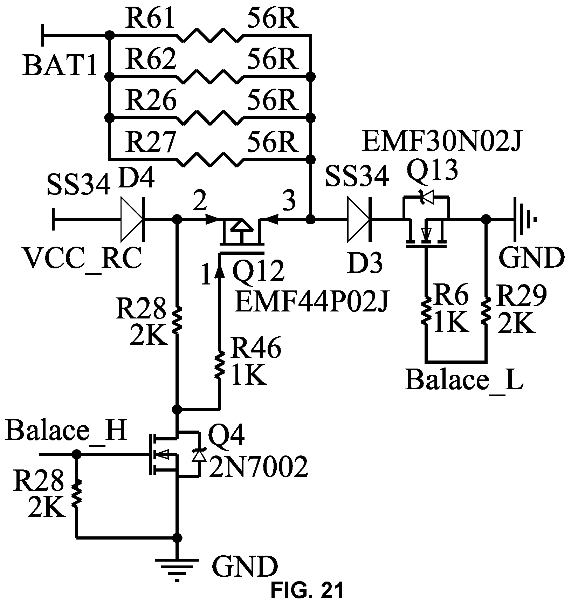

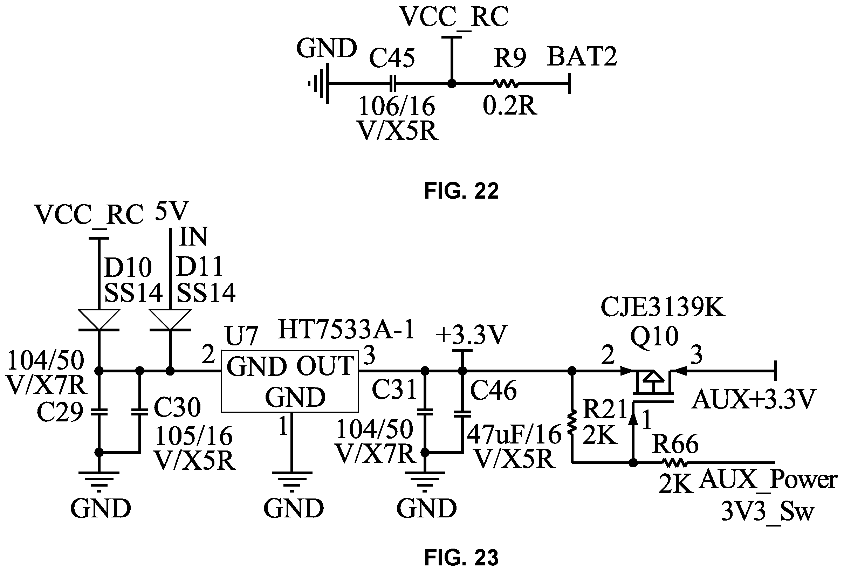

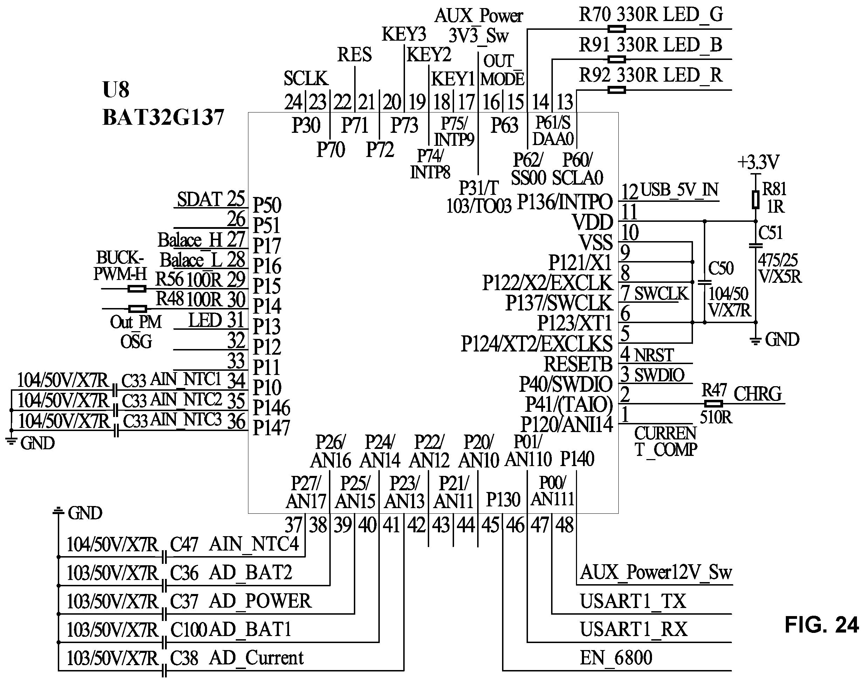

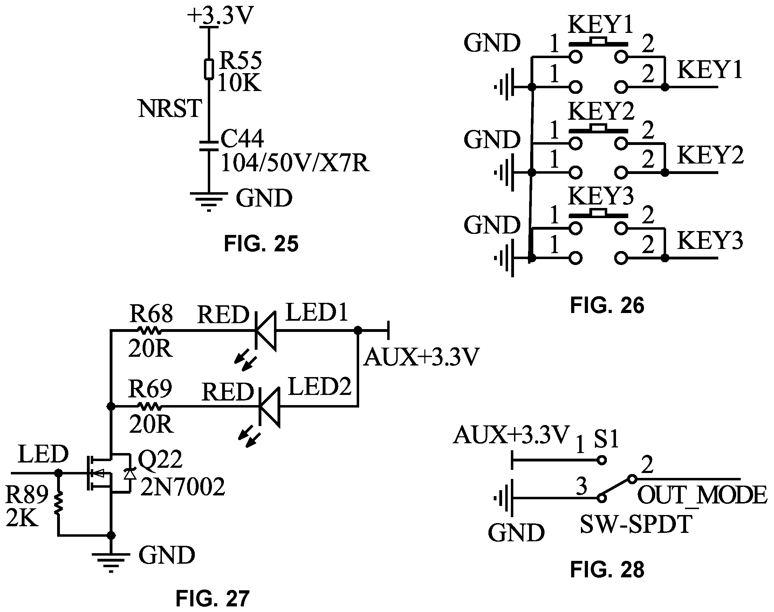

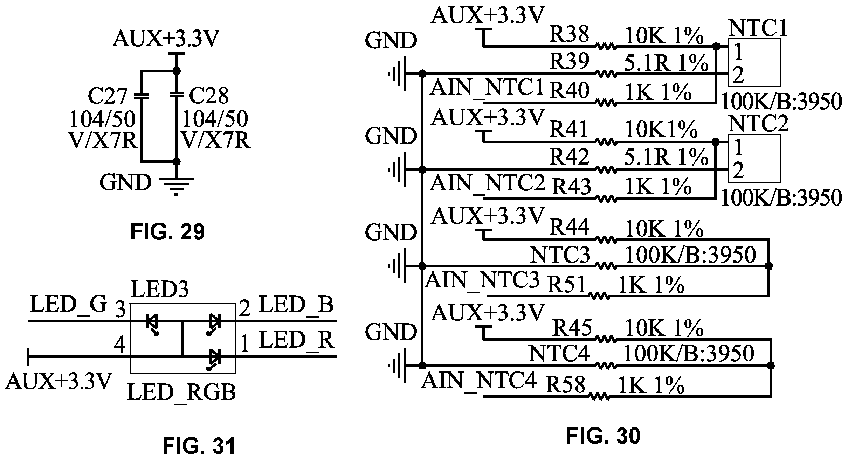

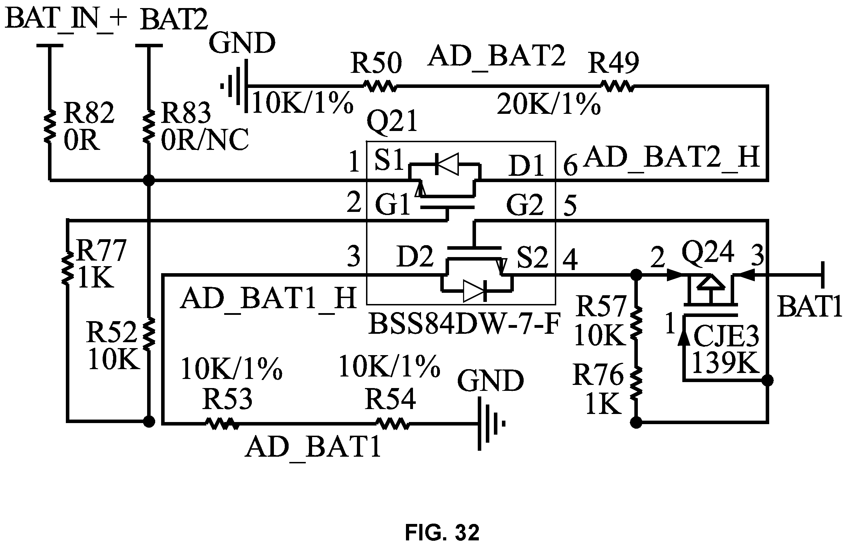

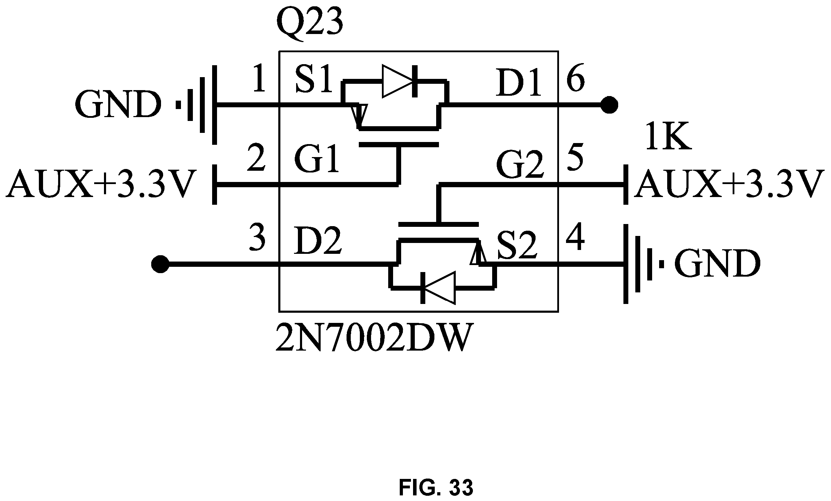

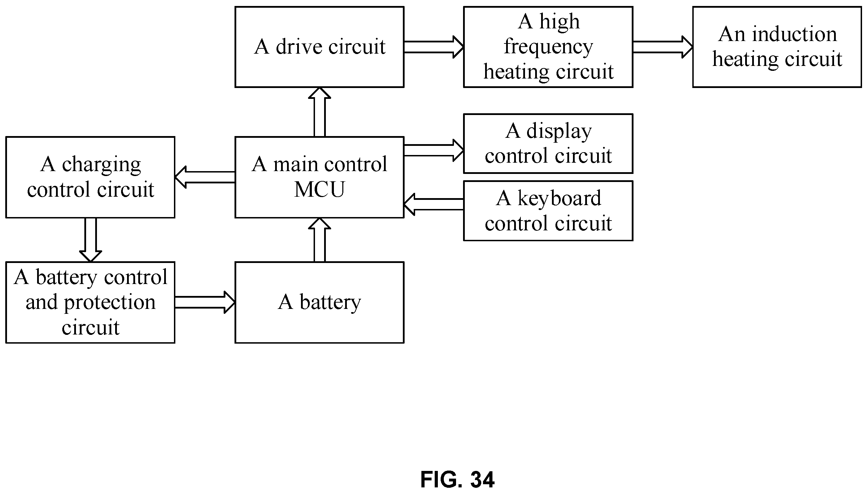

As shown in FIGS. 1-34, the disclosure provides a high-frequency electromagnetic induction control circuit comprising a charging control circuit, a battery, a main control MCU, a display control circuit, a drive circuit, a high-frequency heating circuit, and an induction heating circuit. The charging control circuit supplies a charging voltage and a charging current for the battery. The main control MCU detects the input voltage of the battery, and the display control circuit sends out a signal whether the battery is in the under-voltage state. If not, the main control MCU feeds back the signal to the battery. Thereafter, the input voltage of the battery is boosted by the drive circuit. The boosted voltage is oscillated in the high-frequency heating circuit to produce an electromagnetic wave thus generating high-frequency alternating voltage and current. The high-frequency alternating voltage and current is output to the induction heating circuit to produce an induced magnetic field and an eddy current. The object in the induction heating circuit produces an electromagnetic induction effect and then is heated, achieving the conversion from electromagnetic energy to heat energy.

In certain embodiments, the charging control circuit is configured to convert the household 220V/23A alternating current into the 5V/1A DC charging voltage and charging current for the battery. The battery adopts two 18650 cells connected in series, and each 3.7V. Under full power, 8.4V voltage can be input to supply power to the main control MCU and each circuit.

In certain embodiments, the main control MCU is configured to detect whether the battery is in the under-voltage state after the battery supplies power to the main control MCU. If so, the main control MCU feeds back the signal regarding to the under-voltage state to the display control circuit and the charging control circuit. The display control circuit sends out the signal, and the charging control circuit receives the signal and continues to charge the battery until the battery is fully charged.

In certain embodiments, the drive circuit is equivalent to a step-up transformer to increase the DC voltage from the battery.

In certain embodiments, the high-frequency heating circuit comprises a capacitor and an inductor; the high-frequency heating circuit is configured to oscillate the DC voltage output from the drive circuit to produce the electromagnetic wave, and to change positive and negative directions of the DC voltage periodically, thereby generating the high-frequency alternating voltage and current, and to output the high-frequency alternating voltage and current to the induction heating circuit.

In certain embodiments, the high-frequency alternating voltage and current is output to the induction heating circuit to produce the induced magnetic field and the eddy current. A conductor in the induction heating circuit produces an electromagnetic induction effect and then is heated, achieving the conversion from electromagnetic energy to heat energy.

## Claims

1. A high-frequency electromagnetic induction control circuit, comprising:
a charging control circuit (U3);
a battery control and protection circuit (C18);
a battery (BAT2);
a main control MCU (R55);
a display control circuit (R73);
a keyboard control circuit (P73);
a drive circuit (D4);
a high-frequency heating circuit (C20); and
an induction heating circuit (D10);
whereby:
the charging control circuit is connected to the battery control and protection circuit and supplies a charging voltage and a charging current through the battery control and protection circuit to the battery;
the battery control and protection circuit is connected to the battery and is configured to detect whether the charging voltage and the charging current are qualified for charging the battery;
the battery is connected to and supplies power for the main control MCU;
the main control MCU is connected to the charging control circuit, the display control circuit and the drive circuit and is configured to detect an input voltage of the battery, and the display control circuit sends out a signal whether the battery is in an under-voltage state;
the keyboard control circuit is connected to the main control MCU and is configured to control the main control MCU to operate;
an output voltage of the main control MCU is boosted by the drive circuit; a boosted voltage is oscillated in the high-frequency heating circuit to produce an electromagnetic wave thus generating a high-frequency alternating voltage and current; the high-frequency alternating voltage and current is output to the induction heating circuit to produce an induced magnetic field and an eddy current is formed in a metal placed in the induction heating circuit, and the metal is heated through electromagnetic induction effect.

2. The high-frequency electromagnetic induction control circuit of claim 1, wherein the charging control circuit is configured to convert a household 220V/23A alternating current into a 5V/1A DC charging voltage and charging current for the battery.

3. The high-frequency electromagnetic induction control circuit of claim 2, wherein the battery control and protection circuit is configured to detect whether the charging voltage and charging current meet a voltage and a current required by the battery, thus achieving the functions of over-current and over-voltage protection.

4. The high-frequency electromagnetic induction control circuit of claim 1, wherein the battery comprises at least two cells connected in series or in parallel to supply power for the main control MCU and each circuit.

5. The high-frequency electromagnetic induction control circuit of claim 1, wherein the main control MCU is configured to detect whether the battery is in the under-voltage state after the battery supplies power to the main control MCU; if so, the main control MCU feeds back the signal regarding to the under-voltage state to the display control circuit and the charging control circuit; the display control circuit sends out the signal, and the charging control circuit receives the signal and continues to charge the battery until the battery is fully charged.

6. The high-frequency electromagnetic induction control circuit of claim 1, wherein the keyboard control circuit is configured to control the main control MCU to operate or stop operating, to switch a working mode and power of the main control MCU, to feed back information with regard to a working state, the working mode and power of the main control MCU to the display control circuit; and the display control circuit is configured to display the information.

7. The high-frequency electromagnetic induction control circuit of claim 1, wherein the drive circuit is equivalent to a step-up transformer to increase the DC voltage from the battery.

8. The high-frequency electromagnetic induction control circuit of claim 1, wherein the high-frequency heating circuit comprises a capacitor and an inductor; the high-frequency heating circuit is configured to oscillate a DC voltage output from the drive circuit to produce the electromagnetic wave, and to change positive and negative directions of the DC voltage periodically, thereby generating the high-frequency alternating voltage and current, and to output the high-frequency alternating voltage and current to the induction heating circuit.

9. The high-frequency electromagnetic induction control circuit of claim 8, wherein the induction heating circuit comprises a metal coil and a metal container; the high-frequency alternating voltage and current pass through the metal coil to produce the induced magnetic field, and the metal container is heated in the induced magnetic field.

## Patentansprüche

1. Elektromagnetische Hochfrequenz-Induktionssteuerschaltung, umfassend:
eine Ladesteuerschaltung (U3);
eine Batteriesteuer- und -schutzschaltung (C18);
eine Batterie (BAT2);
eine Hauptsteuerungs-MCU (R55);
eine Anzeigesteuerschaltung (R73);
eine Tastatursteuerschaltung (P73);
eine Treiberschaltung (D4);
eine Hochfrequenz-Heizschaltung (C20); und
eine Induktionsheizschaltung (D10);
wodurch:
die Ladesteuerschaltung mit der Batteriesteuer- und -schutzschaltung verbunden ist und eine Ladespannung und einen Ladestrom durch die Batteriesteuer- und -schutzschaltung an die Batterie liefert;
die Batteriesteuer- und -schutzschaltung mit der Batterie verbunden ist und dazu konfiguriert ist, zu erkennen, ob die Ladespannung und der Ladestrom geeignet sind, um die Batterie aufzuladen;
die Batterie mit der Hauptsteuerungs-MCU verbunden ist und Energie für diese bereitstellt;
die Hauptsteuerungs-MCU mit der Ladesteuerschaltung, der Anzeigesteuerschaltung und der Treiberschaltung verbunden ist und dazu konfiguriert ist, eine Eingangsspannung der Batterie zu erkennen, und die Anzeigesteuerschaltung ein Signal ausgibt, ob sich die Batterie in einem Unterspannungszustand befindet;
die Tastatursteuerschaltung mit der Hauptsteuerungs-MCU verbunden ist und dazu konfiguriert ist, die Hauptsteuerungs-MCU so zu steuern, dass sie betrieben wird;
eine Ausgangsspannung der Hauptsteuerungs-MCU durch die Treiberschaltung erhöht wird; eine erhöhte Spannung in der Hochfrequenz-Heizschaltung oszilliert wird, um eine elektromagnetische Welle zu erzeugen und somit eine Hochfrequenz-Wechselspannung und einen Hochfrequenz-Wechselstrom zu generieren; wobei die Hochfrequenz-Wechselspannung und der Hochfrequenz-Wechselstrom an die Induktionsheizschaltung ausgegeben werden, um ein induziertes Magnetfeld zu erzeugen, und ein Wirbelstrom in einem Metall gebildet wird, das in der Induktionsheizschaltung platziert ist, und das Metall durch elektromagnetischen Induktionseffekt erhitzt wird.

2. Elektromagnetische Hochfrequenz-Induktionssteuerschaltung nach Anspruch 1, wobei die Ladesteuerschaltung dazu konfiguriert ist, einen Haushalts-Wechselstrom von 220 V/23 A in eine(n) Gleich-Ladespannung und -Ladestrom von 5 V/1 A für die Batterie umzuwandeln.

3. Elektromagnetische Hochfrequenz-Induktionssteuerschaltung nach Anspruch 2, wobei die Batteriesteuer- und -schutzschaltung dazu konfiguriert ist, zu erkennen, ob die Ladespannung und der Ladestrom eine Spannung und einen Strom erfüllen, die von der Batterie benötigt werden, und somit die Funktionen des Überstrom- und Überspannungsschutzes erreicht werden.

4. Elektromagnetische Hochfrequenz-Induktionssteuerschaltung nach Anspruch 1, wobei die Batterie mindestens zwei Zellen umfasst, die in Reihe oder parallel geschaltet sind, um Energie für die Hauptsteuerungs-MCU und jede Schaltung zu liefern.

5. Elektromagnetische Hochfrequenz-Induktionssteuerungsschaltung nach Anspruch 1, wobei die Hauptsteuerungs-MCU dazu konfiguriert ist, zu erkennen, ob sich die Batterie in dem Unterspannungszustand befindet, nachdem die Batterie der Hauptsteuerungs-MCU Energie liefert; wenn dies der Fall ist, die Hauptsteuerungs-MCU das Signal in Bezug auf den Unterspannungszustand an die Anzeigesteuerschaltung und die Ladesteuerschaltung zurückspeist; die Anzeigesteuerschaltung das Signal aussendet und die Ladesteuerschaltung das Signal empfängt und die Batterie weiterlädt, bis die Batterie vollständig geladen ist.

6. Elektromagnetische Hochfrequenz-Induktionssteuerschaltung nach Anspruch 1, wobei die Tastatursteuerschaltung dazu konfiguriert ist, die Hauptsteuerungs-MCU so zu steuern, dass sie betrieben wird oder den Betrieb stoppt, um einen Arbeitsmodus und Energie der Hauptsteuerungs-MCU umzuschalten, um Informationen in Bezug auf einen Arbeitszustand, den Arbeitsmodus und die Energie der Hauptsteuerungs-MCU an die Anzeigesteuerschaltung zurückzuspeisen; und die Anzeigesteuerschaltung dazu konfiguriert ist, die Informationen anzuzeigen.

7. Elektromagnetische Hochfrequenz-Induktionssteuerschaltung nach Anspruch 1, wobei die Treiberschaltung einem Aufwärtstransformator entspricht, um die Gleichspannung von der Batterie zu erhöhen.

8. Elektromagnetische Hochfrequenz-Induktionssteuerschaltung nach Anspruch 1, wobei die Hochfrequenz-Heizschaltung einen Kondensator und einen Induktor umfasst; die Hochfrequenz-Heizschaltung dazu konfiguriert ist, eine Gleichspannung, die von der Treiberschaltung ausgegeben wird, zu oszillieren, um die elektromagnetische Welle zu erzeugen, und die positiven und negativen Richtungen der Gleichspannung periodisch zu ändern, wodurch die Hochfrequenz-Wechselspannung und der Hochfrequenz-Wechselstrom generiert werden, und die Hochfrequenz-Wechselspannung und den Hochfrequenz-Wechselstrom an die Induktionsheizschaltung auszugeben.

9. Elektromagnetische Hochfrequenz-Induktionssteuerschaltung nach Anspruch 8, wobei die Induktionsheizschaltung eine Metallspule und einen Metallbehälter umfasst; die Hochfrequenz-Wechselspannung und der Hochfrequenz-Wechselstrom durch die Metallspule fließen, um das induzierte Magnetfeld zu erzeugen, und der Metallbehälter in dem induzierten Magnetfeld erhitzt wird.

## Revendications

1. Circuit de commande d'induction électromagnétique haute fréquence, comprenant :
un circuit de commande de charge (U3) ;
un circuit de commande et de protection de batterie (C18) ;
une batterie (BAT2) ;
un MCU de commande principal (R55) ;
un circuit de commande d'affichage (R73) ;
un circuit de commande de clavier (P73) ;
un circuit d'attaque (D4) ;
un circuit de chauffage haute fréquence (C20) ; et
un circuit de chauffage par induction (D10) ;
moyennant quoi :
le circuit de commande de charge est raccordé au circuit de commande et de protection de batterie et fournit une tension de charge et un courant de charge à travers le circuit de commande et de protection de batterie à la batterie ;
le circuit de commande et de protection de batterie est raccordé à la batterie et est configuré pour détecter si la tension de charge et le courant de charge sont qualifiés pour charger la batterie ;
la batterie est raccordée au MCU de commande principal et alimente celui-ci en électricité ;
le MCU de commande principal est raccordé au circuit de commande de charge, au circuit de commande d'affichage et au circuit de commande et est configuré pour détecter une tension d'entrée de la batterie, et le circuit de commande d'affichage envoie un signal indiquant si la batterie se trouve dans un état de sous-tension ;
le circuit de commande de clavier est raccordé au MCU de commande principal et est conçu pour commander au MCU de commande principal de fonctionner ;
une tension de sortie du MCU de commande principal est amplifiée par le circuit de commande ; une tension amplifiée est mise en oscillation dans le circuit de chauffage haute fréquence pour produire une onde électromagnétique générant ainsi une tension et un courant alternatifs haute fréquence ; la tension et le courant alternatifs haute fréquence sont émis vers le circuit de chauffage par induction pour produire un champ magnétique induit et un courant de Foucault est formé dans un métal placé dans le circuit de chauffage par induction, et le métal est chauffé par effet d'induction électromagnétique.

2. Circuit de commande d'induction électromagnétique haute fréquence selon la revendication 1, ledit circuit de commande de charge étant configuré pour convertir un courant alternatif domestique de 220V/23A en une tension de charge et un courant de charge CC de 5V/1A pour la batterie.

3. Circuit de commande d'induction électromagnétique haute fréquence selon la revendication 2, ledit circuit de commande et de protection de batterie étant configuré pour détecter si la tension de charge et le courant de charge répondent à une tension et à un courant requis par la batterie, réalisant ainsi les fonctions de protection contre les surintensités et les surtensions.

4. Circuit de commande d'induction électromagnétique haute fréquence selon la revendication 1, ladite batterie comprenant au moins deux cellules connectées en série ou en parallèle pour alimenter le MCU de commande principal et chaque circuit.

5. Circuit de commande d'induction électromagnétique haute fréquence selon la revendication 1, ledit MCU de commande principal étant configuré pour détecter si la batterie se trouve dans l'état de sous-tension après que la batterie alimente en électricité le MCU de commande principal ; si tel est le cas, le MCU de commande principal renvoie le signal concernant l'état de sous-tension au circuit de commande d'affichage et au circuit de commande de charge ; le circuit de commande d'affichage envoie le signal, et le circuit de commande de charge reçoit le signal et continue de charger la batterie jusqu'à ce que la batterie soit complètement chargée.

6. Circuit de commande d'induction électromagnétique haute fréquence selon la revendication 1, ledit circuit de commande de clavier étant configuré pour commander au MCU de commande principal de fonctionner ou d'arrêter de fonctionner, pour commuter un mode de fonctionnement et une puissance du MCU de commande principal, pour renvoyer des informations concernant un état de fonctionnement, le mode de fonctionnement et la puissance du MCU de commande principal au circuit de commande d'affichage ; et ledit circuit de commande d'affichage étant configuré pour afficher les informations.

7. Circuit de commande d'induction électromagnétique haute fréquence selon la revendication 1, ledit circuit de commande étant équivalent à un transformateur élévateur pour augmenter la tension CC provenant de la batterie.

8. Circuit de commande d'induction électromagnétique haute fréquence selon la revendication 1, ledit circuit de chauffage haute fréquence comprenant un condensateur et une bobine d'induction ; ledit circuit de chauffage haute fréquence étant configuré pour faire osciller une tension CC émise par le circuit de commande pour produire l'onde électromagnétique, et pour changer périodiquement les directions positive et négative de la tension CC, générant ainsi la tension et le courant alternatifs haute fréquence, et pour émettre la tension et le courant alternatifs haute fréquence vers ledit circuit de chauffage par induction.

9. Circuit de commande d'induction électromagnétique haute fréquence selon la revendication 8, ledit circuit de chauffage par induction comprenant une bobine métallique et un récipient métallique ; ladite tension et ledit courant alternatifs haute fréquence passant à travers la bobine métallique pour produire le champ magnétique induit, et ledit récipient métallique étant chauffé dans le champ magnétique induit.
